# EUROPEAN PATENT SPECIFICATION

(11) **EP 2 096 643 B1**
(45) Date of publication and mention of the grant of the patent: **02.04.2014**
(21) Application number: 09002634.5
(22) Date of filing: 25.02.2009
(51) Int. Cl.: C04B 35/52, C04B 41/52, C04B 41/87, C04B 41/89, G21C 3/07, G21C 21/02

(54) **Nuclear fuel cladding tube and its method of production**
Brennelementhüllrohr und dessen Herstellungsverfahren
Gaine de combustible nucléaire et son procédé de réalisation

(30) Priority: 29.02.2008 JP 2008050324
(43) Date of publication of application: 02.09.2009
(73) Proprietor: Ibiden Co., Ltd., Ogaki-shi, Gifu 503-8604 (JP)
(72) Inventor: Takagi, Takashi, Ogaki, Gifu (JP)
(74) Representative: HOFFMANN EITLE

(56) References cited:
- US-A- 5 391 428
- US-A1- 2006 003 098
- US-A1- 2006 039 524
- US-A1- 2007 189 952

## Description

### BACKGROUND OF THE INVENTION

### Field of the Invention

The present invention relates to a nuclear fuel cladding tube for holding nuclear fuel in a nuclear reactor such as a light-water reactor of a boiling water type, a pressurized water type or the like, a heavy-water reactor, a gas-cooled reactor such as a high-temperature gas reactor or an ultrahigh-temperature gas reactor, a molten metal-cooled reactor or a fast breeder reactor.

### Description of the Related Art

In many nuclear reactors today, nuclear fuel is contained in a sealed metal tube called a "cladding tube", and this cladding tube is generally made of a zirconium alloy or a steel alloy. The cladding tube is designed so that any radioactive gas and solid fission product are securely held in the tube and not released to a coolant during normal operation or during a potential accident. If the cladding tube is damaged, heat, hydrogen and ultimately the fission product can be released to the coolant.

Problems with conventional cladding tubes are known. For example, the metal cladding tube is relatively soft, and may come into contact with one of the fragments that sometimes flow into a cooling system and contact with fuel, so that the metal cladding tube becomes worn or corrodes. Such wear or corrosion may ultimately lead to damage to a boundary wall of a metal containment, and consequently to the release of the fission product into the coolant. Further, the metal cladding tube exothermicly reacts with water heated to 1,000°C or higher, which results in the addition of further heat to the fission product decay heat generated by the nuclear fuel. This additional heat from the cladding further amplifies the seriousness and duration of an accident, as for example occurred at Three Mile Island.

JP-A-2008-501977 describes a multilayer ceramic tube (cladding tube) including an inner layer of monolithic SiC; an intermediate layer as a composite material in which SiC fibers are surrounded by a SiC matrix; and an outer layer of SiC.

However, in such a cladding tube composed entirely of SiC, the monolithic SiC layer is formed by Chemical Vapor Deposition (CVD) or the like, and the inner layer, the intermediate layer and the outer layer all have high rigidity, so that in particular strain generated by an immediate change in temperature occuring at the beginning of an operation can develop into a crack extending from the front to the back of the cladding tube.

In order to prevent such a problem, JP-A-2008-501977 proposes providing each fiber with a double coating including an inside pyrolytic carbon sublayer for preventing the development of cracks and an outside SiC sublayer for protecting carbon from an oxidizing environment. However, in order to provide each fiber with a double coating, each fiber must be dispersed in such a way that a film can be formed on the fiber surface. If each fiber cannot be sufficiently dispersed, it can be coated with only one of the above-described sublayers. Accordingly, the SiC fiber and the SiC matrix would come into contact with each other and the pyrolytic carbon layer would not be able to function sufficiently.

Further, in JP-A-2008-501977, the SiC matrix is formed by two processes for applying the coatings to the SiC fiber surface and a multistage treatment in which CVD or polymer penetration/pyrolysis are repeated. Such a production method is quite complicated since it requires many repetitions of the treatment.

US Patent No. 5,391,428 discloses a shaped ceramic-ceramic composite article comprising a ceramic monolith, in the shape of a hollow tube, having a ceramic fiber matrix thereover, coated with carbonaceous material and overcoated with silicon carbide.

US Patent Application Publication No. US 2006/0003098 A1 discloses a method of producing a densified SiC article, the method comprising the steps of supplying a porous SiC perform having an open porosity; filling pores within the porous silicon carbide perform with a carbon precursor to produce a filled silicon carbide perform; and heating the filled silicon carbide perform to produce a carbonaceous porous structure within the pores of the porous silicon carbide perform such that the resulting densified SiC article exhibits lower porosity than the porous SiC perform.

### SUMMARY OF THE INVENTION

The present invention has been developed in response to such problems, and an object thereof is to provide a nuclear fuel cladding tube that can protect nuclear fuel, is strong enough to stably maintain its protective function in a required use environment, can prevent the occurrence of a crack, and moreover, can be developed by following a simple method; and a method for producing the same.

An aspect of the present invention provides for a nuclear fuel cladding tube that comprises a tubular fiber-reinforced carbonaceous substrate including an aggregate formed of ceramic fibers and a carbonaceous material filled into interstices between the ceramic fibers wherein the carbonaceous material includes pyrolytic carbon; and a SiC layer formed on at least one outer surface of the tubular fiber-reinforced carbonaceous substrate. Silicon atoms are diffused from a boundary region between the fiber-reinforced carbonaceous substrate and the SiC layer to the inside of the fiber-reinforced carbonaceous substrate. The SiC layer is further covered by a CVD-SiC layer.

Another exemplary embodiment of the present invention provides for a method for producing a nuclear fuel cladding tube. The method involves forming an aggregate with ceramic fibers; vapor depositing pyrolytic carbon on the aggregate to form a fiber-reinforced carbonaceous substrate; converting the pyrolytic carbon positioned on at least one outer surface of the fiber-reinforced carbonaceous substrate to SiC through a reaction with a SiO gas to form a SiC layer and depositing SiC on a surface of the SiC layer after forming the SiC layer. In the conversion step silicon atoms are diffused from a boundary region between the fiber-reinforced carbonaceous substrate and the SiC layer to the inside of the fiber-reinforced carbonaceous substrate.

According to the configuration as described above, the ceramic fiber surface contacts with the carbonaceous material so that a crack caused by thermal stress can be stopped at the ceramic fiber surface. Accordingly, it is not likely that a crack will penetrate from the inside to the outside of the tubular body. Moreover, the process can be simplified because pretreating the ceramic fibers with a coating is no longer necessary. Furthermore, a nuclear reactor can be operated at higher temperatures by improving the performance of the nuclear fuel cladding tube, which makes a nuclear reactor with high energy efficiency and a prolonged working life possible.

In particular, the nuclear fuel cladding tube may have a simple structure and be difficult to break in a high-temperature gas reactor using a coolant; obviating the fear of reacting with carbon, and the like.

### BRIEF DESCRIPTION OF THE DRAWINGS

The above and other aspects of the present invention will become more apparent and more readily appreciated from the following description of the exemplary embodiments of the present invention as well as the attached drawings, in which:

Fig. 1 is a view schematically illustrating a section taken on a plane parallel to a central axis of a nuclear fuel cladding tube in a state where a nuclear fuel is covered with the nuclear fuel cladding tube according to an exemplary embodiment;

Fig. 2 is a view schematically illustrating a section in an arbitrary direction of a nuclear fuel cladding tube according to an exemplary embodiment; and

Fig. 3 is a view schematically illustrating a section in an arbitrary direction of a nuclear fuel cladding tube according to another exemplary embodiment of the present invention.

### DETAILED DESCRIPTION

According to an exemplary embodiment of the present invention, the nuclear fuel cladding tube usually has a cylindrical body that is open on one end, but may be closed at the end portion depending on the design of the nuclear reactor. Hereinafter, respective portions of the nuclear fuel cladding tube will be described in detail according to an exemplary embodiment.

The fiber-reinforced carbonaceous substrate is a tubular body including an aggregate formed of ceramic fibers and a carbonaceous material filled into interstices between the ceramic fibers.

The carbonaceous material is herein defined as a material substantially composed of pyrolytic carbon.

Pyrolytic carbon exhibits good adhesion to ceramic fibers, particularly to SiC fibers, and can furthermore provide a high-purity carbonaceous material when a high-purity raw material is used. Chemical Vapor Infiltration (CVI) is used to vapor deposit the pyrolytic carbon onto the aggregate, thereby forming the fiber-reinforced carbonaceous substrate with the carbonaceous material filled in the interstices between the ceramic fibers. CVI is a vacuum film forming method based on the same principle as CVD.

The carbonaceous material of the fiber-reinforced carbonaceous substrate does not have to densely fill all the interstices between the ceramic fibers of the aggregate, and may instead only fill a surface layer of the aggregate, because a sufficient anchor effect can be obtained between the SiC layer and the ceramic fibers even when only the surface layer portion is densely filled.

In the fiber-reinforced carbonaceous substrate, the mass ratio of the ceramic fibers to the whole substrate is preferably from 10% to 50%, and more preferably from 20% to 30%. Less than 10% of the ratio results in a decrease in the strength of the substrate, whereas exceeding 50% of the ratio makes it difficult to hold the ceramic fiber during the compression step preceding CVI treatment, which can easily lead to a deformation in shape.

The thickness of the fiber-reinforced carbonaceous substrate is preferably from 0.3 mm to 2 mm, and more preferably from 0.5 mm to 1.2 mm. Less than 0.3 mm of thickness may make it difficult to have sufficient strength, whereas exceeding 2 mm of thickness results in a tendency for insufficient heat transfer to the coolant.

The SiC layer is defined as a layer substantially composed of SiC, and is usually defined as a layer containing SiC in an amount of 95% by mass or more.

The SiC layer can be obtained by converting the carbonaceous material on a surface of the fiber-reinforced carbonaceous substrate to SiC by means of a reaction with a SiO gas. The SiO gas is, for example, obtained by disposing a mixture of various kinds of silicon such as Si powder-SiO₂ powder, SiC powder-SiO₂ powder or carbon powder-SiO₂ powder as a source on the bottom of a furnace, disposing the fiber-reinforced carbonaceous substrate above it, and carrying out a heat treatment at 1,300 °C to 2,300 °C.

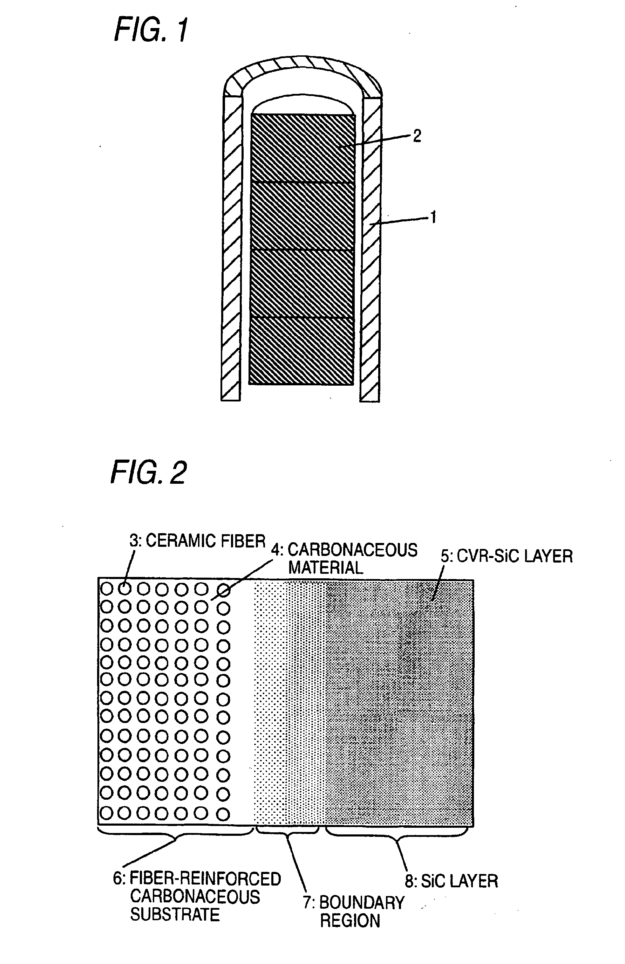

The boundary between the SiC layer (CVR-SiC layer) thus obtained by the reaction conversion and the fiber-reinforced carbonaceous substrate is unclear, and silicon atoms are diffused from the boundary region to the inside of the fiber-reinforced carbonaceous substrate (as shown in Fig. 2, CVR-SiC forms the boundary region 7 and the SiC layer 8 in such a manner that its density gradually increases from the inside of the tube to the outside thereof). In other words, in the boundary region between the fiber-reinforced carbonaceous substrate and the SiC layer 8, the amount of silicon gradually increases from the inside to the outside. In the case of the CVD-SiC layer formed by CVD or the like, diffusion of silicon atoms from a boundary region with the fiber-reinforced carbonaceous substrate to the inside of the fiber-reinforced carbonaceous substrate is not observed.

SiC has a thermal expansion coefficient 2 to 3 times that of the pyrolytic carbon, which leads to the problem that SiC can easily be separated. However, the CVR-SiC layer is originally obtained by converting the carbonaceous material to SiC, which means that there is no clear boundary between the two materials. This configuration thus has the advantage that interlayer separation is not likely to occur.

Further, a SiC layer is newly deposited on the surface of the SiC layer according to the exemplary embodiment. The CVD-SiC layer is formed using the CVD method. The CVD-SiC layer is higher in density, so that it exhibits low reactivity with a heating medium such as cooling water or molten metal and has a high shielding effect. This provides for a nuclear fuel cladding tube with a long life.

If the CVD-SiC layer is further laminated on the surface of the cladding tube, the CVR-SiC layer and the CVD-SiC layer on the surface thereof are formed of the same material at an interface therebetween so that they are approximately equal in thermal expansion and have strong adhesive force. The advantage of this is that it forms a SiC layer that is not as susceptible to interlayer separation.

The thickness of the SiC layer according to the exemplary embodiment is preferably from 10 µm to 500 µm, and more preferably from 20 µm to 100 µm. The advantages of the exemplary embodiment are evident within this range. A thickness of less than 10 µm results in the tendency of the carbonaceous material layer to become exposed by abrasion, whereas exceeding 500 µm in thickness may result in a decrease in the carbonaceous material of the fiber-reinforced carbonaceous substrate.

If the CVD-SiC layer is further coated (laminated) on the SiC layer according to the exemplary embodiment, the thickness thereof is preferably from 2 µm to 300 µm, and more preferably from 10 µm to 100 µm. When less than 2 µm, the CVD-SiC layer may contain thinner sections, which fail to provide a sufficient shielding effect. When more than 300 µm, this leads to an increased dimension error due to an unevenness in the thickness of the formed layer, and moreover, the hardness of the SiC makes it difficult to carry out modifications.

Possible raw materials used for the ceramic fibers of the aggregate are SiC, carbon, ZrC and the like. Of these, SiC is preferred, and ZrC is particularly preferred for ultrahigh-temperature gas reactors. These are difficult to react with the coolant, and also exhibit heat resistance.

Although there is no particular limit to the thickness of the ceramic fibers, ceramic fibers can be used that have a diameter of 10 µm to 20 µm. Should a strand be used, one composed of 100 to 1,000 fibers is suitable to the purpose.

As for the aggregate constituting the fiber-reinforced carbonaceous substrate of the tubular body, according to the exemplary embodiment there is no particular limitation to its structure, as long as it has a tubular form. However, it is preferably formed of strands of ceramic fibers wound together using a winding method, or by braiding strands into a hollow braid mesh body. The braid is formed by weaving strands of ceramic fibers diagonally aligned to a central axis of an inner core die, or by means of a triaxial weave using strands parallel to the central axis.

The winding methods used to form the tubular body according to the exemplary embodiment include a sheet winding method that involves winding a sheet such as a woven fabric, and the like, as well as a filament winding method that involves winding a filament.

A method for producing the nuclear fuel cladding tube according to the present invention will be described in detail below (see Fig. 2).

### (1) Aggregate Forming Step

The tubular aggregate according to the exemplary embodiment can be obtained by winding ceramic fibers around an inner core die having a specific size using a method such as filament winding or braiding.

In a braid form, it is particularly advantageous to form the aggregate by using a triaxial weave made up of warp yarns and two pairs of weft yarns rounded in the opposite direction to each other. In the case of the triaxial weave, the warp yarns are added as braces to the two pairs of weft yarns to provide a nuclear fuel cladding tube with high rigidity and the ability to suppress tension applied to the individual fibers.

The ceramic fibers may be any fibers. High-Nicalon manufactured by Nippon Carbon Co., Ltd. can for example be utilized as the SiC fibers. Although the material used for the inner core die is not limited to a particular kind, it is advantageous to use graphite because it does not react in the CVD step described later and the like.

To ensure that the aggregate can easily be released from the mold, the inner core die is preferably coated with a release agent. Although the release agent used is not limited to a particular kind, it is advantageous to use a graphite powder or graphite-based release agent because this ensures easy mold release after CVD without having to fear that impurities were also added.

### (2) Carbonaceous Material Forming Step

The carbonaceous materials include pyrolytic carbon obtained by CVI. Pyrolytic carbon obtained by CVI (CVD) offers the greatest advantages because a high-purity carbonaceous material is easily obtained by upgrading the purity of the raw material gas used, and the carbonaceous material is moreover obtained through a single treatment in which the raw material gas is supplied continuously.

CVI (CVD) is performed in a CVI (CVD) furnace at a degree of vacuum of 1 kPa to 30 kPa and a temperature of about 1,200°C to 1,900°C using a hydrocarbon gas as a raw material and hydrogen as a carrier gas.

Further, in order to achieve a SiC layer of sufficient thickness in a subsequent SiC layer forming step, the treatment may be continued after the carbonaceous material has been filled into the interstices between the fibers of the aggregate to allow a thick carbonaceous material layer composed of only the pyrolytic carbon to grow on a surface of the fiber-reinforced carbonaceous substrate. When the CVI (CVD) treatment is stopped once the carbonaceous material has been filled into the interstices between the fibers of the aggregate, only a carbonaceous layer composed of only the pyrolytic carbon having a thickness of at most about 100 µm is formed on the surface of the fiber-reinforced carbonaceous substrate. However, continuing with the treatment ensures that a carbonaceous material layer composed only of the pyrolytic carbon is achieved that will make it possible to form a SiC layer of sufficient thickness.

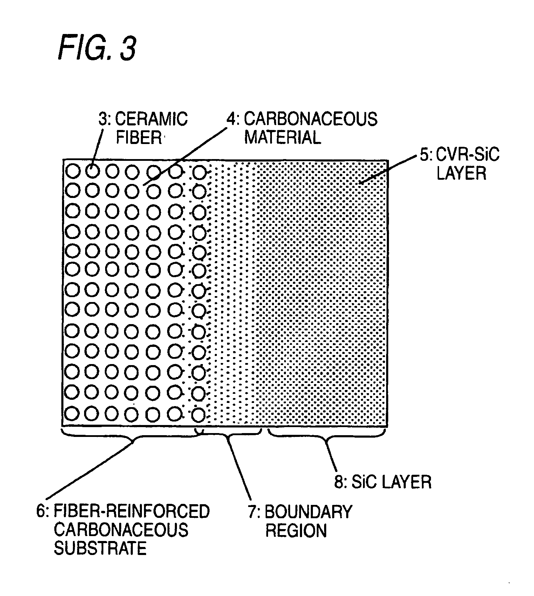

If a carbonaceous material layer composed only of the pyrolytic carbon is not formed in the carbonaceous material forming step that will make it possible to form a SIC layer of sufficient thickness, a nuclear fuel cladding tube in which silicon atoms are diffused to an inside of the carbonaceous material of the fiber-reinforced carbonaceous substrate can be obtained, as shown in Fig. 3.

### (3) SiC Layer Forming Step

As for an intermediate product produced as described above, a surface of the pyrolytic carbon is subjected to the following chemical vapor reaction (CVR) in a SiO₂ gas, using a reaction furnace of atmospheric pressure at a temperature of 1,200°C to 2,300°C, which makes it possible to obtain a CVR-SiC layer composed of reaction-converted SiC.

2C+SiO→SiC+CO↑

The SiC layer may be formed not only on an outer surface of the fiber-reinforced carbonaceous substrate but also on an inner surface thereof.

If the SiC layers are formed on both surfaces, the tubular aggregate is placed in a CVD furnace as it is, and the pyrolytic carbon undergoes CVI (CVD) treatment, followed by SiC conversion treatment in a reaction furnace, thereby reaction-converting the outer surface and the inner surface to perform SiC conversion. Further, the SiC layers can also be formed on both surfaces by inserting an inner core die into the tubular aggregate, subjecting the pyrolytic carbon to CVI (CVD) treatment in the CVD furnace to obtain a fiber-reinforced carbonaceous substrate, then drawing the inner core die out, and reaction-converting the outer surface and the inner surface in a reaction furnace to perform SiC conversion.

As described above, according to the exemplary embodiment, the nuclear fuel cladding tube having a CVR-SiC layer on its outer surface can be obtained by carrying out the following three steps: (1) the aggregate forming step, (2) the carbonaceous material forming step and (3) the SiC layer forming step. This process is greatly simplified in comparison to the techniques presented in the related art, such as JP-A-2008-501977.

Furthermore, a CVD-SiC layer is deposited thereon to increase the airtightness of the CVR-SiC layer. It is obtained by using methyltrichlorosilane (MTS: CH₃Cl₃Si) as a raw material gas, and performing deposition in a CVD furnace at a degree of vacuum of 5 kPa to 30 kPa and a temperature of about 1,000°C to 1,400°C.

[Examples]

A more specific configuration of the nuclear fuel cladding tube according to an exemplary embodiment and a production method thereof will be described with reference to the following examples. The present invention is not limited to this production method, and any method may be used, as long as it results in the nuclear fuel cladding tube according to the present invention.

### (1) Aggregate Forming Step

First, a rod-like inner core die is prepared for forming a triaxial weave braid. An inner core die made of graphite is used to avoid a reaction during the CVD step.

The size (diameter) of the inner core die is approximately equal to the size of a nuclear fuel (diameter: 8 to 11 mm).

Ribbon-like strands are formed by bundling a plurality of SiC fibers, and the strands are woven into a braid along an outer periphery of a forming die using a three-dimensional braiding method. A commercially available automatic loom (for example, TWM-32C, TRI-AX, manufactured by Howa Machinery, Ltd.) is utilized for weaving the strands.

It is advantageous to use high-purity SiC fibers for the SiC fibers.

### (2) Carbonaceous Material Forming Step

The aggregate obtained in the above-described step is placed into a CVD furnace of pyrolytic carbon, and the pyrolytic carbon is deposited into interstices between the SiC fibers. At this time, using propane as a raw material and hydrogen as a carrier gas, the pyrolytic carbon is deposited into the interstices between the SiC fibers at temperatures of about 1,700°C for about 1 hour, thereby obtaining a fiber-reinforced carbonaceous substrate having a thickness of 1 mm and containing a carbonaceous material in an amount of 20% by mass.

### (3) SiC Layer Forming Step

A surface of the fiber-reinforced carbonaceous substrate obtained in the above-described step is converted to SiC by means of a reaction with a SiO gas in a reaction furnace. The SiO gas is generated from a source mounted in the furnace, in which a SiC powder and a SiO₂ powder are mixed, and the conversion can be suitably performed at a reaction temperature of 1,900°C, atmospheric pressure and a reaction time of 1 hour in an argon atmosphere. A CVR-SiC layer has a thickness of 10 µm.

### (4) CVD-SiC Deposition Step

The nuclear fuel cladding tube according to the exemplary embodiment can be produced by the above-described steps (1) to (3). However, in order to increase airtightness, a CVD-SiC layer is further deposited on the reaction-converted SiC surface. The above-described intermediate product is placed in a CVD furnace, and film formation is performed at 1,350 °C using a methyltrichlorosilane gas. CVD-SiC layer has a thickness of 20 µm.

The nuclear fuel cladding tube according to the exemplary embodiment can be obtained by the above-described method. An example using this nuclear fuel cladding tube 1 for a nuclear fuel 2 is shown in Fig. 1.

While the present invention has been shown and described with reference to certain exemplary embodiments thereof, it will be understood by those skilled in the art that various changes in form and details may be made therein without departing from the scope of the invention as defined by the appended claims.

## Claims

1. A nuclear fuel cladding tube (1) comprising:
a tubular fiber-reinforced carbonaceous substrate (6) including an aggregate formed of ceramic fibers (3) and a carbonaceous material (4) filled into interstices between the ceramic fibers (3), wherein the carbonaceous material includes pyrolytic carbon; and
a SiC layer (8) formed at least on an outer surface of the tubular fiber-reinforced carbonaceous substrate (6),
**characterized in that**:
silicon atoms are diffused from a boundary region (7) between the fiber-reinforced carbonaceous substrate (6) and the SiC layer (8) to the inside of the fiber-reinforced carbonaceous substrate (6); and
the nuclear fuel cladding tube further comprises a CVD-SiC layer formed on the SiC layer (8).

2. The nuclear fuel cladding tube according to claim 1,
wherein the aggregate constituting the fiber-reinforced carbonaceous substrate is produced by forming the ceramic fibers into a tubular form by a winding method.

3. The nuclear fuel cladding tube according to claim 1,
wherein the aggregate constituting the fiber-reinforced carbonaceous substrate is a hollow mesh body formed by weaving strands comprising the ceramic fibers into a braid form.

4. The nuclear fuel cladding tube according to any one of claims 1 to 3,
wherein a mass ratio of the ceramic fibers to the fiber-reinforced carbonaceous substrate ranges from 10% to 50%.

5. The use of the nuclear fuel cladding tube according to any one of claims 1 to 4 as a nuclear fuel cladding tube.

6. A method for producing a nuclear fuel cladding tube (1), the method comprising:
forming an aggregate with ceramic fibers (3);
vapor depositing pyrolytic carbon on the aggregate to form a fiber-reinforced carbonaceous substrate (6);
converting the pyrolytic carbon positioned at least on an outer surface of the fiber-reinforced carbonaceous substrate (6) to SiC by reaction with a SiO gas to form a SiC layer (8), wherein silicon atoms are diffused from a boundary region (7) between the fiber-reinforced carbonaceous substrate (6) and the SiC layer (8) to the inside of the fiber-reinforced carbonaceous substrate (6) during the converting step; and
depositing SiC by CVD on a surface of the SiC layer after forming the SiC layer.

7. The method according to claim 6,
wherein a mass ratio of the ceramic fibers to the fiber-reinforced carbonaceous substrate ranges from 10% to 50%.

8. The method according to claim 6 or 7,
wherein the thickness of the fiber-reinforced carbonaceous substrate ranges from 0.3 mm to 2 mm.

9. The method according to any one of claims 6 to 8,
wherein forming the aggregate comprises forming the ceramic fibers into a tubular form by a winding method.

10. The method according to any one of claims 6 to 8,
wherein forming the aggregate comprises weaving strands including the ceramic fibers into a braid form to have a hollow mesh body.

## Patentansprüche

1. Kernbrennstoff-Auskleidungsrohr (1), umfassend:
ein röhrenförmiges faserverstärktes kohlenstoffhaltiges Substrat (6), das ein Aggregat aus Keramikfasern (3) und ein kohlenstoffhaltiges Material (4), welches in die Zwischenräume zwischen den Keramikfasern (3) gefüllt ist, enthält, wobei das kohlenstoffhaltige Material pyrolytischen Kohlenstoff einschließt; und
eine SiC-Schicht (8), die auf mindestens einer Außenfläche des röhrenförmigen faserverstärkten kohlenstoffhaltigen Substrats (6) gebildet ist, **dadurch gekennzeichnet, dass**:
Siliziumatom von einem Randbereich (7) zwischen dem faserverstärkten kohlenstoffhaltigen Substrat (6) und der SiC-Schicht (8) zu der Innenseite des faserverstärkten kohlenstoffhaltigen Substrats (6) diffundiert sind; und
das Kernbrennstoff-Auskleidungsrohr ferner eine CVD-SiC-Schicht, die auf der SiC-Schicht (8) gebildet ist, umfasst.

2. Kernbrennstoff-Auskleidungsrohr gemäß Anspruch 1, wobei das Aggregat, welches das faserverstärkte kohlenstoffhaltige Substrat bildet, hergestellt wird, indem die Keramikfasern in eine röhrenförmige Form durch ein Wickelverfahren gebracht werden.

3. Kernbrennstoff-Auskleidungsrohr gemäß Anspruch 1, wobei das Aggregat, welches das faserverstärkte kohlenstoffhaltige Substrat bildet, ein Hohlgitterkörper ist, der durch Weben von Strängen, die die Keramikfasern umfassen, in Form eines Geflechts gebildet wird.

4. Kernbrennstoff-Auskleidungsrohr gemäß einem der Ansprüche 1 bis 3, wobei das Massenverhältnis der Keramikfasern zu dem faserverstärkten kohlenstoffhaltigen Substrat im Bereich von 10 % bis 50 % liegt.

5. Verwendung des Kernbrennstoff-Auskleidungsrohrs gemäß einem der Ansprüche 1 bis 4 als ein Kernbrennstoff-Auskleidungsrohr.

6. Verfahren zur Herstellung eines Kernbrennstoff-Auskleidungsrohrs (1), wobei das Verfahren umfasst:
Bildung eines Aggregats mit Keramikfasern (3);
Gasphasenabscheidung von pyrolytischem Kohlenstoff auf dem Aggregat, um ein faserverstärktes kohlenstoffhaltiges Substrat (6) zu bilden;
Umwandlung des pyrolytischen Kohlenstoffs, der wenigstens an einer Außenfläche des faserverstärkten kohlenstoffhaltigen Substrats (6) angeordnet ist, in SiC durch Reaktion mit SiO-Gas, um eine SiC-Schicht (8) zu bilden, wobei während des Umwandlungsschritts Siliziumatome von einem Randbereich (7) zwischen dem faserverstärkten kohlenstoffhaltigen Substrat (6) und der SiC-Schicht (8) zu der Innenseite des faserverstärkten kohlenstoffhaltigen Substrats (6) diffundieren; und
Abscheidung von SiC durch CVD auf einer Oberfläche der SiC-Schicht nach Bildung der SiC-Schicht.

7. Verfahren gemäß Anspruch 6, wobei das Massenverhältnis der Keramikfasern zu dem faserverstärkten kohlenstoffhaltigen Substrat im Bereich von 10 % bis 50 % liegt.

8. Verfahren gemäß Anspruch 6 oder 7, wobei die Dicke des faserverstärkten kohlenstoffhaltigen Substrats im Bereich von 0,3 mm bis 2 mm liegt.

9. Verfahren gemäß einem der Ansprüche 6 bis 8, wobei die Bildung des Aggregats die Formung der Keramikfasern in einer röhrenförmigen Form durch ein Wickelverfahren umfasst.

10. Verfahren gemäß einem der Ansprüche 6 bis 8, wobei die Bildung des Aggregats das Weben von Strängen, die die Keramikfasern enthalten, in Form eines Geflechts umfasst, um einen Hohlgitterkörper zu erhalten.

## Revendications

1. Tube de gainage de combustible nucléaire (1) comprenant :
un substrat carboné tubulaire (6) renforcé par des fibres comportant un agrégat formé de fibres de céramique (3) et un matériau carboné (4) introduit dans des interstices entre les fibres de céramique (3), où le matériau carboné comporte du carbone pyrolytique ; et
une couche de SiC (8) formée au moins sur une surface externe du substrat carboné tubulaire (6) renforcé par des fibres,
**caractérisé en ce que** :
des atomes de silicium sont diffusés à partir d'une région de frontière (7) entre le substrat carboné (6) renforcé par des fibres et la couche de SiC (8) jusqu'à la partie intérieure du substrat carboné (6) renforcé par des fibres ; et
le tube de gainage de combustible nucléaire comprend en outre une couche de SiC déposé par CVD formée sur la couche de SiC (8).

2. Tube de gainage de combustible nucléaire selon la revendication 1,
dans lequel l'agrégat constituant le substrat carboné renforcé par des fibres est produit en formant des fibres de céramique sous forme tubulaire par le biais d'un procédé d'enroulement.

3. Tube de gainage de combustible nucléaire selon la revendication 1,
dans lequel l'agrégat constituant le substrat carboné renforcé par des fibres est un corps creux à mailles formé par le tissage de torons comprenant les fibres de céramique sous forme de tresse.

4. Tube de gainage de combustible nucléaire selon l'une quelconque des revendications 1 à 3,
dans lequel un rapport de masse des fibres de céramique sur le substrat carboné renforcé par des fibres se trouve dans la plage allant de 10% à 50%.

5. Utilisation du tube de gainage de combustible nucléaire selon l'une quelconque des revendications 1 à 4 en tant que tube de gainage de combustible nucléaire.

6. Procédé de production d'un tube de gainage de combustible nucléaire (1), le procédé comprenant :
la formation d'un agrégat avec des fibres de céramique (3) ;
le dépôt sous vide du carbone pyrolytique sur l'agrégat afin de former un substrat carboné (6) renforcé par des fibres ;
la conversion du carbone pyrolytique positionné au moins sur une surface externe du substrat carboné (6) renforcé par des fibres en SiC par réaction avec un gaz de SiO afin de former une couche de SiC (8), où des atomes de silicium sont diffusés à partir d'une région de frontière (7) entre le substrat carboné (6) renforcé par des fibres et la couche de SiC (8) jusqu'à la partie intérieure du substrat carboné (6) renforcé par des fibres pendant l'étape de conversion ; et
le dépôt du SiC par CVD sur une surface de la couche de SiC après la formation de la couche de SiC.

7. Procédé selon la revendication 6,
dans lequel un rapport de masse des fibres de céramique sur le substrat carboné renforcé par des fibres se trouve dans la plage allant de 10% à 50%.

8. Procédé selon la revendication 6 ou 7,
dans lequel l'épaisseur du substrat carboné renforcé par des fibres se trouve dans la plage allant de 0,3 mm à 2 mm.

9. Procédé selon l'une quelconque des revendications 6 à 8,
dans lequel la formation de l'agrégat comprend la formation des fibres de céramique sous forme tubulaire par le biais d'un procédé d'enroulement.

10. Procédé selon l'une quelconque des revendications 6 à 8,
dans lequel la formation de l'agrégat comprend le tissage de torons comportant les fibres de céramique sous forme de tresse de manière à avoir un corps creux à mailles.
